# EUROPEAN PATENT SPECIFICATION

(11) **EP 3 358 040 B1**
(45) Date of publication and mention of the grant of the patent: **27.11.2019**
(21) Application number: 15905288.5
(22) Date of filing: 01.10.2015
(51) Int. Cl.: C23C 16/455, B65D 23/02, C23C 16/44, C23C 16/04

(54) **FILM-FORMING DEVICE**
VORRICHTUNG ZUR FILMHERSTELLUNG
DISPOSITIF DE FORMATION DE FILM

(43) Date of publication of application: 08.08.2018
(73) Proprietor: Mitsubishi Heavy Industries Machinery Systems, Ltd., Hyogo-ku Kobe-shi Hyogo 652-8585 (JP)
(72) Inventor: MIZUKAWA, Kenji, Hyogo 652-8585 (JP); HIROYA, Kiyoshi, Hyogo 652-8585 (JP); NAKANISHI, Fumikazu, Hyogo 652-8585 (JP)
(74) Representative: Hoffmann Eitle
(86) International application number: PCT/JP2015/005018
(87) International publication number: WO 2017/056133

(56) References cited:
- EP-A1- 2 799 593
- WO-A1-94/00247
- WO-A1-95/21948
- WO-A1-2013/099960
- JP-A- 2013 133 494
- JP-A- 2013 534 565
- US-A1- 2007 254 097

## Description

### Technical Field

The present invention relates to a film-forming device which is preferable to form a film having gas barrier properties in a resin container.

### Background Art

In resin containers, a film having gas barrier properties has been formed on their inner peripheral surfaces. This film having gas barrier properties is formed for several purposes. For example, the film aims to prevent oxygen from permeating into the container from outside and to ensure the quality of a product liquid filling the container. In addition, the film aims to prevent carbon dioxide contained in carbonated drinks from permeating out via the container.

As a film having gas barrier properties (hereinafter, will be referred to as a barrier film), as disclosed in JP 2008-231468 A and WO 2012-91097 A1, various kinds of films including hard carbon films such as diamond-like carbon (DLC), and silica (SiO₂) films, and the like have been proposed.

These barrier films can be formed through various methods. A chemical vapor deposition (CVD) method is one of the representative film-forming methods, and a plasma CVD method is known as a typical example among thereof (JP 2008-231468 A). In the plasma CVD method, a medium gas (raw material) is decomposed by means of plasma and is ionized in a film-forming chamber in a vacuum state, and ions accelerated by an electric field collide with each other, thereby forming a film.

WO 2012-91097 A1 and WO 2013-99960 A1 disclose a catalytic chemical vapor deposition (Cat-CVD) method which is known as an alternative CVD method other than the plasma CVD method. In the Cat-CVD method, a medium gas is decomposed on a surface of a linear heat generating body or a catalytic body which has been energized and heated inside a film-forming chamber, and generated chemical species are deposited directly or after undergoing a reaction process in a gas phase, thereby forming a film. The Cat-CVD method is also referred to as a heat generating body CVD method or a hot wire CVD method.

In regard to the Cat-CVD method, WO 2013-99960 A1 discloses a film-forming device including a vacuum chamber which performs film-forming using a heat generating body on a surface of a container in a vacuum state, vacuum exhaust means for performing vacuum drawing of the vacuum chamber, and relative movement means for causing the container and the heat generating body to relatively move inside the vacuum chamber after vacuum drawing of the vacuum chamber starts. According to the film-forming device of WO 2013-99960 A1, a place which can be a restriction of a film-forming time from the viewpoint of thermal deformation can be subjected to film-forming only for a short period of time, and other parts can be sufficiently subjected to film-forming. As a result, barrier properties of the entire container can be easily improved.

As described above, in the Cat-CVD method, a linear heat generating body generates heat by being energized inside the film-forming chamber when film-forming is performed. In order to efficiently decompose the medium gas, the temperature of heat-generation is set within a range from 1, 550°C to 2, 400°C. Therefore, the heat generating body is formed of a material containing one or more metallic elements selected from the group consisting of tungsten (W), molybdenum (Mo), zirconium (Zr), tantalum (Ta), vanadium (V), niobium (Nb), and hafnium (Hf) known as high-melting metals. As the material, a pure metal, an alloy, or a metal carbide formed of the metallic elements can be selected. Among the metallic elements, a material containing one or more metallic elements selected from the group consisting of Mo, W, Zr, and Ta is preferably employed.

EP 2799593 A1 discloses an apparatus for forming thin film, the apparatus comprising: a vacuum chamber in which film formation upon a surface of a container is performed in a vacuum state by using a heat generating element; a vacuum evacuation device that evacuates said vacuum chamber; and a relative shifting device that, after evacuation of said vacuum chamber has started, shifts the container and said heat generating element relatively to each other within the vacuum chamber.

WO 9400247 A1 discloses a method of treating a hollow article, the method comprising the steps of providing a first gas on the inside of said article so that said first gas substantially fills said article; providing a second gas including electrically charged species on the outside of said article while maintaining said second gas separate from said first gas; maintaining said first gas in an electrically conductive state; and applying a first electrical potential to a first electrode in contact with said first gas whereby said first potential is applied and the interior surfaces of said article and said electrically charged species in said second gas interact with the exterior surfaces of said article under the influence of said potential.

US 2007/0254097 A1 discloses a container treatment method, the type in which the container is disposed inside a chamber which defines a cavity outside the container and which is connected to a vacuum pumping circuit, wherein the interior of the container is connected to the pumping circuit.

WO 9521948 A1 discloses a method of coating the internal surface of a temperature sensitive container.

### Summary of Invention

### Technical Problem

As disclosed in PTL 3, in a Cat-CVD method, film-forming is performed by causing a heat generating body to generate heat after a vacuum chamber is subjected to vacuum drawing. However, since the temperature of heat-generation easily exceeds 1,000°C, if a very small amount of oxygen is included inside the vacuum chamber, the heat generating body is oxidized. A heat generating body which has been oxidized in a greater or less degree is no longer able to function as a heat generating body.

Therefore, an object of the present invention is to provide a film-forming device which can prevent the heat generating body from being oxidized when a gas barrier film is formed through the Cat-CVD method.

### Solution to Problem

A film-forming device in accordance with the present invention is defined by claim 1. Dependent claims relate to preferred embodiments. According to the present invention made based on the object, there is provided a film-forming device including a chamber which has a film-forming chamber accommodating a container for forming a gas barrier film, wherein the film-forming device is configured such that the film-forming chamber is in a vacuum state when the gas barrier film is formed; a gas supply pipe which has a gas flow channel introducing a medium gas used for forming the gas barrier film into the container and is movable upward and downward along an axis line direction thereof; a cylinder in which the gas supply pipe is arranged movably upward and downward; and a heat generating body configured to generate heat when power is supplied.

According to the present invention, the gas supply pipe includes a first supply pipe adapted to advance and retreat in the film-forming chamber, wherein the first supply pipe internally has a first gas flow channel, and wherein the first supply pipe is adapted to discharge the medium gas from a tip end toward the heat generating body, and a second supply pipe which internally has a second gas flow channel in communication with the first gas flow channel and is connected to the first supply pipe.

According to the present invention, the cylinder includes a first cylinder in which the first supply pipe is arranged movably upward and downward, has a pressure-reducing chamber in communication with the first gas flow channel, and is fixed to the chamber, and a second cylinder in which the second supply pipe is arranged movably upward and downward and has a storage chamber in communication with the second gas flow channel. The film forming device is configured such that medium gas supplied to the storage chamber passes through the second supply pipe and the first supply pipe in this order and is supplied to the container.

According to the film-forming device of the present invention, since the medium gas can always be sprayed to the heat generating body when necessary, it is possible to prevent deterioration of the heat generating body caused due to oxidation and nitration. Furthermore, according to the present invention, the gas supply pipe is divided into the first supply pipe and the second supply pipe, and the medium gas is supplied to the second supply pipe via the second cylinder in which the second supply pipe moves upward and downward. That is, since the second supply pipe and the second cylinder behave as a piston-cylinder mechanism, the members can be produced with a raw material having high rigidity, such as a metallic material.

Here, it is possible to use a gas supply pipe using a flexible material such as rubber and a synthetic resin. However, since this gas supply pipe has ventilation properties, the medium gas leaks out. In such a case, there is concern that the medium gas required for the heat generating body cannot be supplied. In contrast, according to the present invention, since the piston-cylinder mechanism which can restrain ventilation is used, the medium gas can be prevented from leaking out of a place other than a discharge part.

According to the present invention, it is preferable that the film-forming device further includes a heat generating unit which is supported by the first supply pipe. It is preferable that the heat generating unit has the heat generating body which generates heat when power is supplied and a pair of leads which is electrically connected to the heat generating body. It is preferable that the heat generating body is disposed in the vicinity of the tip end of the first supply pipe gas.

In the film-forming device of the present invention, the second cylinder may be fixed to the chamber in a state of being adjacent to the first cylinder.

In the film-forming device of the present invention, it is preferable that the first supply pipe is constituted of a tip portion of which a length of a portion accommodated in the first cylinder is L1 while being on standby during which no gas barrier film is formed, and a rear end portion which is connected to the tip portion and of which a length of a portion accommodated in the first cylinder is L2 during film-forming. It is preferable that when a length of the second supply pipe 23 is L3, L1 ≤ L2 and L1 ≤ L3 are satisfied.

In the film-forming device of the present invention, it is preferable that the first supply pipe is retreatable from the film-forming chamber and is accommodatable in the first cylinder while being on standby during which no gas barrier film is formed, and the first gas flow channel is subjected to vacuum drawing.

According to the present invention, it is preferable that the film-forming device further includes a shielding gate which is configured to block communication between the film-forming chamber and the pressure-reducing chamber when the first supply pipe retreats from the film-forming chamber.

In the film-forming device of the present invention, it is preferable that the film forming device is configured such that medium gas is supplied to the film-forming chamber via the gas supply pipe continuously as much as a predetermined period of time while being on standby after forming of the gas barrier film ends.

In the film-forming device of the present invention, it is preferable that the first supply pipe and the second supply pipe are arranged reversed, and connected to each other via a connection pipe.

### Advantageous Effects of Invention

According to the present invention, since the medium gas can always be sprayed to the heat generating body when necessary, it is possible to prevent deterioration of the heat generating body caused due to oxidation and nitration. Furthermore, according to the present invention, since the second supply pipe and the second cylinder behave as a piston-cylinder mechanism, the members can be produced with a raw material having high rigidity, such as a metallic material. Therefore, there is no need to use a flexible material. Thus, according to the present invention, the medium gas can be prevented from leaking out of the gas supply pipe, so that film-forming can be stably performed.

### Brief Description of Drawings

Figs. 1A and 1B are longitudinal sectional views illustrating a schematic configuration of a film-forming device according to an embodiment.
Fig. 2A illustrates a step of container supplying, Fig. 2B illustrates a step of vacuum drawing and gas scavenging, and Fig. 2C illustrates a step of gate opening and nozzle lowering, in the procedure of Fig. 5.
Figs. 3A and 3B illustrate a step of film-forming (start of film-forming and completion of film-forming), and Fig. 3C illustrates a step of nozzle raising and gate closing, in the procedure of Fig. 5.
Fig. 4A illustrates a step of atmosphere exposing, and Fig. 4B illustrates a step of container discharging, in the procedure of Fig. 5.
Fig. 5 is a flow chart illustrating a procedure of forming a barrier film in a container by using the film-forming device of the present embodiment.

### Description of Embodiment

Hereinafter, the invention will be described in detail based on an embodiment illustrated in the accompanying drawings.

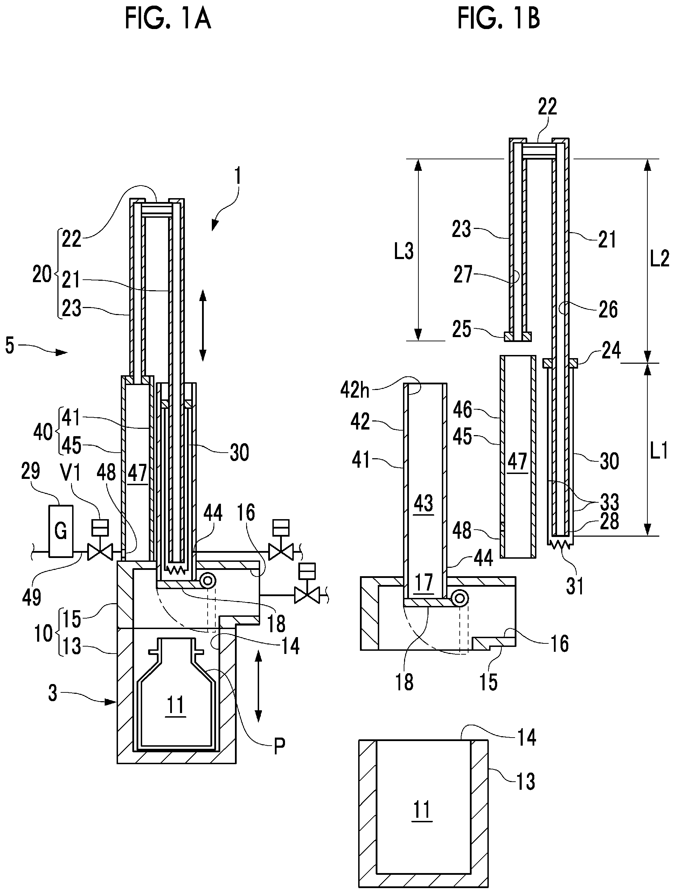

According to the present embodiment illustrated in Figs. 1A and 1B, a film-forming device 1 forms a barrier film on an inner surface of a resin container P through a Cat-CVD method and is configured to prevent oxidation of a heat generating unit 30.

For example, the film-forming device 1 is applied to a system in which the container P is filled with drinks. As an example, this system can include a container forming portion that forms the container P, a film-forming portion that forms a barrier film on an inner peripheral surface of the formed container P, a filling portion that causes a filling gap of the container P in which the barrier film is formed on the inner peripheral surface to be filled with drinks, and a capping portion that puts a cap on the resin container filled with the drinks. In this beverage filling system, each of the elements including the container forming portion, the film-forming portion, the filling portion, and the capping portion is configured to be a rotary mechanism. A transfer device for delivering the container P can be provided between the elements. However, the film-forming device 1 can employ a batch-type configuration.

As illustrated in Figs. 1A and 1B, the film-forming device 1 includes a film-forming portion 3 that forms a barrier film in the resin container P, and a gas transportation portion 5 that transports a medium gas G to the film-forming portion 3.

The film-forming portion 3 includes a vacuum chamber 10 as a main constituent element. In addition, the gas transportation portion 5 includes a gas supply pipe 20 that is disposed inside the container P so as to be insertable and removable and supplies a medium gas to the inside of the container P, the heat generating unit 30 that is supported by the gas supply pipe 20, and a cylinder 40 that accommodates the gas supply pipe 20 and the heat generating unit 30, as main constituent elements.

Hereinafter, the constituent elements of the film-forming device 1 will be described in order.

### [Vacuum Chamber 10]

The vacuum chamber 10 provided in the film-forming portion 3 includes a cylindrical lower chamber 13 of which one end (upper end) in an axial direction is open, and an upper chamber 15 which is mounted on an upper portion of the lower chamber 13 so as to be attachable and detachable with respect to the lower chamber 13. In the vacuum chamber 10, an internal space formed by the lower chamber 13 and the upper chamber 15 accommodates the container P and configures a film-forming chamber 11 forming a gas barrier film.

In the present embodiment, the container P is accommodated in the lower chamber 13. The container P is carried into and carried out from the lower chamber 13 through an opening (entry way 14) formed at an upper end of the lower chamber 13. Therefore, the internal space of the lower chamber 13 is formed to be slightly larger than the outer shape of the container P to be accommodated therein. In the upper chamber 15, when the container P is carried into the lower chamber 13, the entry way 14 is closed. In addition, when the container P is carried into and carried out from the lower chamber 13, the entry way 14 is opened. In the present embodiment, the position of the upper chamber 15 in a vertical direction (upward-downward direction in Figs. 1A and 1B) is fixed, and the lower chamber 13 moves upward and downward as indicated with the double-headed arrows by an actuator (not illustrated). However, a reversed configuration may be employed as long as the lower chamber 13 and the upper chamber 15 relatively move and the film-forming chamber 11 is sealed and exposed. In order to ensure a sealing state between the lower chamber 13 and the upper chamber 15, a seal material such as an O-ring can be provided between both the chambers.

The upper chamber 15 includes an exhaust passage 16. In this exhaust passage 16, one end communicates with the entry way 14 of the lower chamber 13 and the other end is connected to an exhaust pump (not illustrated) . When the lower chamber 13 and the upper chamber 15 are in a sealed state and the exhaust pump operates, gas components inside the film-forming chamber 11 and the container P are discharged, so that the film-forming chamber 11 and the container P are in a pressure-reduced state, and preferably in a vacuum state. The aforementioned term "pressure-reduced" denotes a state of pressure lower than the atmospheric pressure.

In the upper chamber 15, a through-window 17 in which the gas supply pipe 20 and the heat generating unit 30 advance and retreat is provided so as to penetrate a top wall of the upper chamber 15. A tip portion of a first cylinder 41 is inserted into the through-window 17 so as to reach the film-forming chamber 11 and is fixed to the upper chamber 15. The gas supply pipe 20 and the heat generating unit 30 advance and retreat in the through-window 17 through the inside of the first cylinder 41.

A tool which is also referred to as a gripper for gripping the container P is provided inside the vacuum chamber 10. A barrier film can be formed while a neck part of the container P is gripped by the gripper.

The upper chamber 15 supports the cylinder 40. In the first cylinder 41 of the cylinder 40, one end positioned below thereof penetrates the front and the rear of the upper chamber 15 and is fixed to the upper chamber 15. A pressure-reducing chamber 43 inside thereof is in communication with the film-forming chamber 11. However, an oscillating-type shielding gate 18 which opens and closes the opening of the first cylinder 41 leading to the film-forming chamber 11 is provided in the exhaust passage 16 of the upper chamber 15. When the shielding gate 18 is closed, the pressure-reducing chamber 43 of the cylinder 40 forms a closed space. In addition, a second cylinder 45 of the cylinder 40 is provided so as to be adjacent to the first cylinder 41. One end positioned below thereof is fixed so as to be sealed by the upper chamber 15. More specific configuration of the cylinder 40 will be described below.

It is preferable that a structure for causing cooling water to circulate is provided in one or both the inside and outside of the vacuum chamber 10 so as to prevent a temperature rise of the lower chamber 13 and the upper chamber 15. It is preferable that this cooling structure is provided particularly for the lower chamber 13 because the container P, in which the heat generating unit 30 serving as a heat source when forming a barrier film is inserted, is just accommodated in the lower chamber 13.

In addition, in the vacuum chamber 10, it is preferable that the inner surfaces of the lower chamber 13 and the upper chamber 15 facing the film-forming chamber 11 are subjected to processing for preventing reflection of light emitted in accordance with heat generation of the heat generating unit 30. As this processing, the inner surfaces may be colored in black or fine uneven surfaces may be employed. Accordingly, a temperature rise of the container P can be suppressed.

A material configuring the vacuum chamber 10 is arbitrary as long as the material has predetermined properties such as heat resistance and corrosion resistance. An aluminum alloy can be preferably used.

### [Gas Supply Pipe 20]

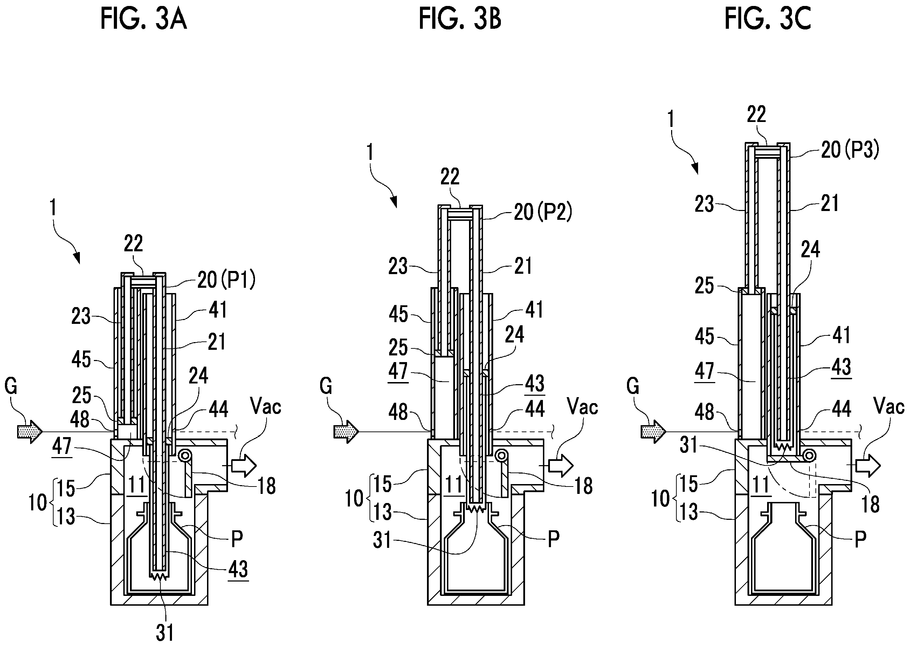

Subsequently, the gas supply pipe 20 configuring the gas transportation portion 5 introduces the medium gas G stored in a raw material tank 29 into the film-forming chamber 11 of the vacuum chamber 10. The gas supply pipe 20 is supported so as to be movable upward and downward along an axis line direction by an actuator (not illustrated) between a film-forming start position P1 (Fig. 3A) at the time of forming a barrier film and a standby position P3 (Fig. 3C) at the time of being on standby during which no film is formed.

As illustrated in Figs. 1A and 1B, the gas supply pipe 20 includes a first supply pipe 21, a second supply pipe 23, and a connection pipe 22 connecting end portions of the first supply pipe 21 and the second supply pipe 23 with each other. The first supply pipe 21 and the second supply pipe 23 are assembled so as to be disposed adjacent to each other in parallel. A first gas flow channel 26 penetrating the first supply pipe 21 in the axial direction is formed in the first supply pipe 21. A second gas flow channel 27 penetrating the second supply pipe 23 in the axial direction is formed in the second supply pipe 23. In the gas supply pipe 20, the first supply pipe 21 is inserted into the container P when a barrier film is formed, and the first supply pipe 21 is set to have a dimension in the axial direction longer than that of the second supply pipe 23 as much as the inserted part.

That is, the first supply pipe 21 is divided into the tip portion lower than a first piston 24 and a rear end portion above thereof. As illustrated in Fig. 1B, the lengths of the tip portion and the rear end portion are respectively L1 and L2. In addition, when the length of the second supply pipe 23 is L3, the gas supply pipe 20 satisfies L1 ≤ L2 and L1 ≤ L3.

Since these relationships are satisfied, the tip portion of the first supply pipe 21 is accommodated in the first cylinder 41 while being on standby during which no barrier film is formed, and is inserted deep into the container P of the film-forming chamber 11 during film-forming. In the present embodiment, since L1 and L2 are approximately equal to each other, the rear end portion is accommodated in the first cylinder 41 during film-forming. Meanwhile, in this process, the second supply pipe 23 is placed outside the second cylinder 45 while being on standby but is accommodated inside the second cylinder 45 during film-forming. In the case of the present embodiment, since the lengths of the first cylinder 41 and the second cylinder 45 are approximately equal to each other, the lengths L2 and L3 are also approximately equal to each other.

In the first supply pipe 21, one end side (lower end side) is open, and the other end side (upper end side) communicates with the second supply pipe 23 via the connection pipe 22. In the second supply pipe 23, one end side (lower end side) is open, and the other end side (upper end side) communicates with the first supply pipe 21 via the connection pipe 22.

The first piston 24 is fitted on an outer peripheral surface of the first supply pipe 21 at a predetermined position in the axial direction. The first piston 24 is in tight contact with an inner wall surface of the first cylinder 41, thereby sealing the upper side and the lower side of the first piston 24 inside the first cylinder 41. In addition, the first piston 24 has a function of supporting the heat generating unit 30. In order to have these two functions, the first piston 24 is formed of an electrically insulative ceramic material.

A second piston 25 is fitted to the lower end of the second supply pipe 23. The second piston 25 is in tight contact with an inner wall surface of the second cylinder 45 and has a function of sealing the upper side and the lower side of the second piston 25. The second piston 25 may also have a configuration similar to that of the first piston 24.

After passing through the connection pipe 22 via the second supply pipe 23, the medium gas G flows in the first supply pipe 21 in a reverse direction and is discharged from the opening at a tip end of the first supply pipe 21. Hereinafter, this tip end part is also referred to as a nozzle 28.

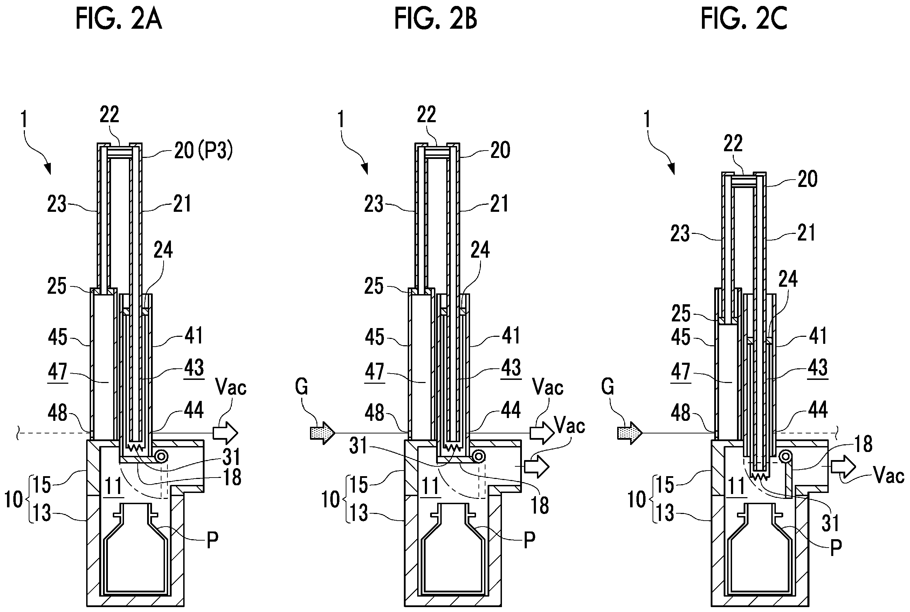

When the gas supply pipe 20 is at the standby position P3 as illustrated in Figs. 2A and 3C, the tip portion lower than the first piston 24 of the first supply pipe 21 is accommodated inside the first cylinder 41, and the second supply pipe 23 retreats above the second cylinder 45, except for the part of the second piston 25. In addition, the gas supply pipe 20 is at the film-forming start position P1 as illustrated in Fig. 3A, the tip portion lower than the first piston 24 of the first supply pipe 21 is accommodated inside the film-forming chamber 11, and the second supply pipe 23 is accommodated inside the second cylinder 45.

The gas supply pipe 20 is formed of a material which is heat resistant and electrically insulative. The gas supply pipe 20 can be formed of a simple single pipe member and can be formed integrally with a cooling pipe. As this structure, for example, the gas supply pipe 20 can have a dual pipe structure, such that the inside of an inner pipe structure serves as a flow channel for a medium gas and the space between the inner pipe structure and an outer pipe structure serves as a flow channel in which the cooling water flows.

The gas supply pipe 20 is required to be insulative in order to maintain its form without melting even if the heat generating unit 30 generates heat of a high temperature exceeding 1,000°C during film-forming and to prevent an electric short-circuit with respect to the energized heat generating unit 30. A ceramic material satisfying the requirements can be used for the gas supply pipe 20. However, in consideration of cooling performance, it is preferable to use a ceramic material such as aluminum nitride, silicon carbide, silicon nitride, and aluminum oxide having high thermal conductivity. In addition, without being limited to the ceramic material, a metallic material such as stainless steel and a super heat-resistant alloy can be used for the gas supply pipe 20. In a case where a metallic material is used, its surface can be covered with the ceramic material described above.

### [Heat Generating Unit 30]

Subsequently, when power is received from a power source (not illustrated), the heat generating unit 30 generates heat and promotes decomposition of the medium gas G supplied from the gas supply pipe 20 to the inside of the container P.

The heat generating unit 30 includes a heat generating body 31 and a pair of leads 33 of which the tip end side (lower end in Figs. 1A and 1B) is electrically connected to the heat generating body 31. The rear end side of the leads 33 is supported by the first piston 24, and the leads 33 move upward and downward following the gas supply pipe 20 moving upward and downward.

In the heat generating unit 30, a part carrying out heat generation required to form a film is the heat generating body 31, and the leads 33 function only as electric wires in which power from the power source flows toward the heat generating body 31. That is, in the heat generating unit 30, only the heat generating body 31 part can be selectively caused to generate heat. The heat generating body 31 is formed in a coil shape in order to increase the opportunity of contact with the supplied medium gas G. However, it is allowed to employ a different form such as a linear shape.

The heat generating unit 30 is formed in a U-shape which is folded back at the heat generating body 31 part. The heat generating body 31 is disposed in the vicinity of the nozzle 28 at the tip end of the first supply pipe 21, so that the medium gas G supplied from the gas supply pipe 20 is sprayed without leakage.

The heat generating body 31 generates heat by being energized. In order to efficiently decompose the medium gas, the temperature of heat-generation is set within a range from 1,550°C to 2,400°C. Therefore, the heat generating body 31 is formed of a material containing one or more metallic elements selected from the group consisting of tungsten (W), molybdenum (Mo), zirconium (Zr), tantalum (Ta), vanadium (V), niobium (Nb), and hafnium (Hf) known as high-melting metals. As the material, a pure metal, an alloy, or a metal carbide formed of the metallic elements can be selected. Among the metallic elements, a material containing one or more metallic elements selected from the group consisting of Mo, W, Zr, and Ta is preferably employed.

The leads 33 are formed of a material having low electric resistance, for example, copper, aluminum, and an alloy thereof.

In the present embodiment, the heat generating unit 30 is heated by being energized. However, as long as the medium gas G can be decomposed, the heat generation method for the heat generating body in the present invention is not limited to energizing and heating.

### [Cylinder 40]

As illustrated in Figs. 1A and 1B, the cylinder 40 includes the first cylinder 41 and the second cylinder 45. When a lower end of the first cylinder 41 is inserted into the through-window 17, the first cylinder 41 is erected from the upper chamber 15. In addition, the second cylinder 45 is erected on the upper chamber 15 while its lower end is in contact with the top surface thereof adjacent to the first cylinder 41.

The first cylinder 41 includes a cylinder main body 42 and the pressure-reducing chamber 43 which is provided inside the cylinder main body 42. As described above, the cylinder main body 42 penetrates the through-window 17 of the upper chamber 15. When the first supply pipe 21 of the gas supply pipe 20 moves upward and downward in the pressure-reducing chamber 43, the first supply pipe 21 advances and retreats with respect to the film-forming chamber 11. The pressure-reducing chamber 43 occupies a region lower than the first piston 24, and the volume of the second supply pipe 23 continuously changes in accordance with the first supply pipe 21 moving upward and downward. At this time, the cylinder main body 42 also functions to guide upward/downward movement of the gas supply pipe 20.

An exhaust port 44 through which the pressure-reducing chamber 43 and the outside of the cylinder main body 42 communicate with each other is provided in the cylinder main body 42, and the exhaust port 44 is connected to the exhaust pump (not illustrated). When the exhaust pump operates on the premise that the shielding gate 18 is closed, the pressure-reducing chamber 43 is in a pressure-reduced state, and preferably in a vacuum state (for example, within a range approximately from 2×10⁻² to 8×10⁻² Torr). When the gas supply pipe 20 is at the standby position P3, the first gas flow channel 26 communicates with the pressure-reducing chamber 43 of the cylinder 40. When the pressure in the pressure-reducing chamber 43 is reduced, the first gas flow channel 26 is in a pressure-reduced state.

The second cylinder 45 includes a cylinder main body 46, a storage chamber 47 which is provided inside the cylinder main body 42, and an air supply port 48 which penetrates the front and the rear of the cylinder main body 46. The storage chamber 47 occupies a region lower than the second piston 25, when the second supply pipe 23 of the gas supply pipe 20 moves upward and downward in the storage chamber 47, its volume continuously changes. At this time, the cylinder main body 42 also functions to guide upward/downward movement of the gas supply pipe 20.

The air supply port 48 and the raw material tank 29 storing the medium gas G are connected to each other via piping 49, and the medium gas G stored in the raw material tank 29 is supplied to the storage chamber 47 in response to an opening-closing operation of an opening-closing valve V1.

The volumes of the pressure-reducing chamber 43 and the storage chamber 47 are minimized when the gas supply pipe 20 is at the film-forming start position P1 (Fig. 3A) and are maximized when the gas supply pipe 20 is at the standby position P3 (Fig. 2B).

### [Procedure of Film-forming]

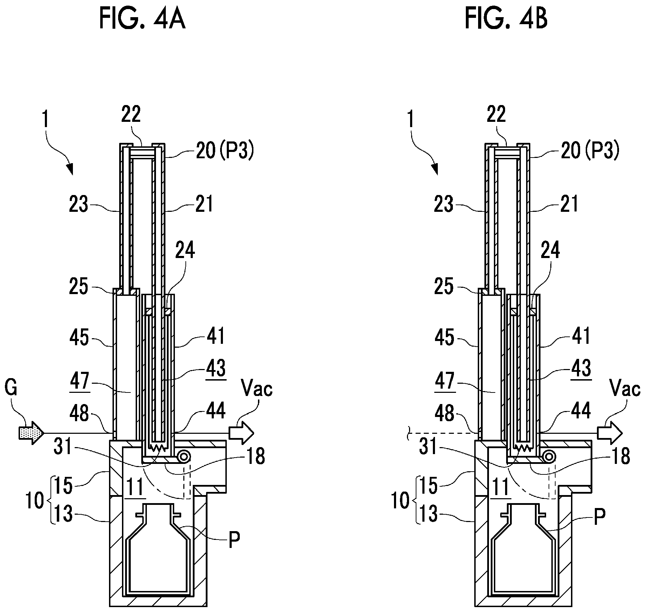

Subsequently, an example of a series of procedures for forming a barrier film in the container P by using the film-forming device 1 will be described with reference to Figs. 2A to 4B. In Figs. 2A to 4B, a part of the elements of the film-forming device 1 is omitted.

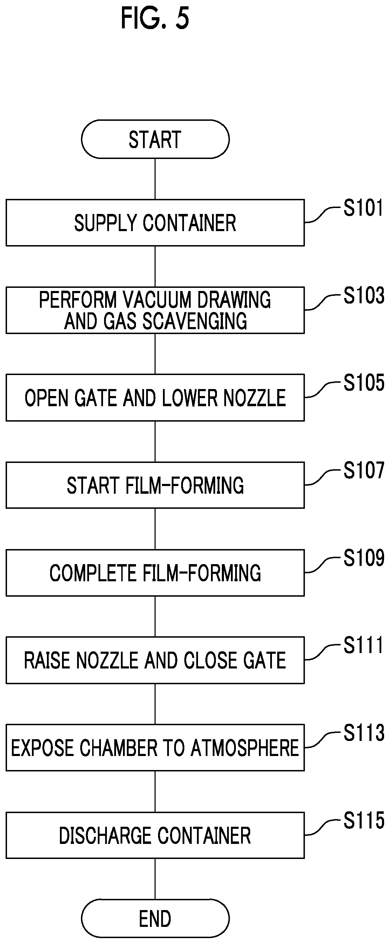

### [Step of Container Supplying (Fig. 2A, S101 in Fig. 5)]

When the container P formed in an upstream step is transported to the film-forming device 1, the container P is accommodated in the film-forming chamber 11 of the lower chamber 13 being on standby at a position which has sufficiently retreated from the upper chamber 15. Thereafter, the lower chamber 13 abuts the upper chamber 15, and the film-forming chamber 11 is held in an air tight manner with respect to the outside.

At this time, the gas supply pipe 20 is placed at the standby position P3 which has treated from the vacuum chamber 10. The pressure-reducing chamber 43 and the storage chamber 47 are in the widest state. In addition, the shielding gate 18 closes the opening of the first cylinder 41, and the pressure-reducing chamber 43 forms a closed space except for the exhaust port 44.

In addition, at this time, the gas supply pipe 20 (first gas flow channel 26 and second gas flow channel 27) is subjected to vacuum drawing Vac through the pressure-reducing chamber 43 by means of the exhaust pump (not illustrated). This vacuum drawing Vac continues to the next step.

### [Step of Vacuum Drawing and Gas Scavenging (Fig. 2B, S103 in Fig. 5)]

Subsequently, the exhaust pump (not illustrated) is operated so that the film-forming chamber 11 is subjected to the vacuum drawing Vac, thereby being prepared for film-forming. At the same time as this vacuum drawing Vac, the medium gas G stored in the raw material tank 29 is supplied toward the storage chamber 47 of the second cylinder 45. The supplied medium gas G passes through the second supply pipe 23, the connection pipe 22, and the first supply pipe 21 in this order. In the first supply pipe 21, the nozzle 28 positioned at the tip end is closed by the shielding gate 18. Accordingly, the supplied medium gas G is discharged out of the system through the exhaust port 44 in a manner of pushing out air contained in the pressure-reducing chamber 43. When both the vacuum drawing Vac and supplying of the medium gas G are continuously performed, the inside of the pressure-reducing chamber 43 is scavenged by the medium gas G, and it is possible to minimize the remaining air.

### [Opening Gate and Lowering Nozzle (Fig. 2C, S105 in Fig. 5)]

After both the vacuum drawing Vac and supplying of the medium gas G are performed as much as a predetermined time, at the same time as opening of the shielding gate 18, the gas supply pipe 20 starts to move downward. The gas supply pipe 20 moves downward until the gas supply pipe 20 reaches the film-forming start position P1 (Fig. 3A). In addition, at the same time as opening of the shielding gate 18, vacuum drawing from the first cylinder 41 and the first supply pipe 21 stops and switches to the vacuum drawing Vac of the inside of the film-forming chamber 11 by means of the exhaust pump connected to the vacuum chamber 10. In addition to the film-forming chamber 11, the pressure-reducing chamber 43 of the first cylinder 41 and the first gas flow channel 26 of the first supply pipe 21 are also subjected to vacuum drawing. At this point of time, the medium gas G continues to be supplied.

When pressure inside the cylinder 40 is reduced and air is discharged, the gas supply pipe 20 moves downward and the first supply pipe 21 is inserted into the container P accommodated in the film-forming chamber 11. At this time, the exhaust pump still continues to discharge air until the inside of the film-forming chamber 11 reaches a desired degree of vacuum. The degree of vacuum at this time ranges approximately from 10⁻¹ to 10⁻⁵ Torr.

The air inside the pressure-reducing chamber 43 of the cylinder 40 may be discharged in the step of container feeding or the step of vacuum chamber closing prior to the step of vacuum drawing. The degree of vacuum at this time ranges approximately from 10⁻¹ to 10⁻⁵ Torr similar to the degree of vacuum of the film-forming chamber 11.

### [Completion of Nozzle Lowering and Start of Film-forming (Fig. 3A, S107 in Fig. 5)]

When the gas supply pipe 20 moves downward until the gas supply pipe 20 reaches the film-forming start position P1, and when the film-forming chamber 11 reaches the desired degree of vacuum, power is supplied from the power source (not illustrated) such that the heat generating body 31 of the heat generating unit 30 generates heat.

When power is supplied to the heat generating unit 30, the film-forming device 1 shifts from a standby period or a standby state to a film-forming period or a film-forming state. At the same time, the gas supply pipe 20 starts to move upward toward the standby position P3. The medium gas G continues to be supplied from the raw material tank 29, and the medium gas G supplied to the storage chamber 47 passes through the second supply pipe 23, the connection pipe 22, and the first supply pipe 21 in this order, thereby being sprayed into the container P. The sprayed medium gas G comes into contact with the heat generating body 31 when passing through the heat generating body 31. Consequently, the medium gas G is decomposed and chemical species are generated. When the chemical species reach the inner surface of the container P, a barrier film is then formed. Vacuum exhaust continues while film-forming is performed.

### [Completion of Film-forming (Fig. 3B, S109 in Fig. 5)]

When the gas supply pipe 20 reaches a film-forming completion position P2, power stops being supplied to the heat generating unit 30. However, supplying of the medium gas G and the operation (Vac) of the exhaust pump continue. The medium gas G is continuously supplied so that the medium gas G is sprayed to the heat generating body 31 even after film-forming. Therefore, the heat generating body 31 can be prevented from being in contact with air.

When power stops being supplied to the heat generating unit 30, film-forming is completed. The film-forming device 1 shifts from the film-forming period or the film-forming state to the standby period or the standby state.

### [Completion of Nozzle Raising and Gate Closing (Fig. 3C, S111 in Fig. 5)]

After completion of film-forming, the gas supply pipe 20 is caused to further retreat. When the gas supply pipe 20 reaches the standby position P3, the shielding gate 18 is closed. Since the inner wall surfaces of the first piston 24 and the first supply pipe 21 are in tight contact with each other, the pressure-reducing chamber 43 of the first cylinder 41 forms a closed space except for the exhaust port 44.

Supplying of the medium gas G and the vacuum drawing Vac of the film-forming chamber 11 still continue at this time.

### [Atmosphere Exposing (Fig. 4A, S113 in Fig. 5)]

When the shielding gate 18 is closed, the film-forming chamber 11 of the vacuum chamber 10 is exposed to the atmosphere.

Although the vacuum drawing Vac of the film-forming chamber 11 stops before being exposed to the atmosphere, supplying of the medium gas G is continuously performed. However, in order to avoid a pressure rise of the pressure-reducing chamber 43 and the storage chamber 47, the vacuum drawing Vac of the gas supply pipe 20 (first supply pipe 21 and second supply pipe 23) is performed.

### [Container Discharging (Fig. 4B, S115 in Fig. 7)]

After the lower chamber 13 moves downward to a required position, the container P having a barrier film formed therein is transferred toward a downstream step by means of appropriate transportation means. The film-forming device 1 is in a standby state until another container P (next processing subject) is transferred. In the standby state, the vacuum drawing Vac of the pressure-reducing chamber 43 continues.

### [Operation and Effect]

Subsequently, effects realized by the film-forming device 1 will be described.

First, according to the film-forming device 1, since the medium gas G can always be sprayed to the heat generating body 31, it is possible to prevent deterioration of the heat generating body 31 caused due to oxidation and nitration.

Here, the film-forming device 1 makes linear reciprocating motion in the vertical direction as much as a stroke corresponding to an extent that the first supply pipe 21 advances and retreats in the film-forming chamber 11. In a case of using a raw material tank 29 of which the position is fixed, a gas supply path leading from the raw material tank 29 to the first supply pipe 21 requires a portion which absorbs this linear reciprocating motion. When a piping in which a pipe formed of a flexible raw material such as a resin is spirally wound is used between the first supply pipe 21 and the raw material tank 29, the linear reciprocating motion can be absorbed. However, since the first supply pipe 21 is disposed in the pressure-reducing chamber 43 to be subjected to vacuum drawing, at least a part of the piping formed of a flexible raw material connected to the first supply pipe 21 is placed in the pressure-reducing chamber 43 to be subjected to vacuum drawing. Since a flexible raw material is not considered to have sufficient air-tight properties in an environment of vacuum drawing, the medium gas G leaks out of the piping. In such a condition, the medium gas G cannot be satisfactorily supplied to the inside of the container P. Therefore, in the present embodiment, without using a flexible raw material, a structure of absorbing linear reciprocating motion is employed.

That is, in the gas transportation portion 5 of the present embodiment, the gas supply pipe 20 is divided into the first supply pipe 21 and the second supply pipe 23, and the medium gas G is supplied to the second supply pipe 23 via the second cylinder 45 in which the second supply pipe 23 moves upward and downward. That is, since the second supply pipe 23 and the second cylinder 45 behave as a piston-cylinder mechanism, the members can be produced with a raw material having high rigidity and having no ventilation properties, such as a metallic material. Therefore, there is no need to use a flexible raw material. The same also applies to the first supply pipe 21 connected to the second supply pipe 23 and the first cylinder 41 accommodating the first supply pipe 21.

Furthermore, in the present embodiment, since the first supply pipe 21 and the second supply pipe 23 are formed to be folded back, the dimension of the film-forming device 1 in the vertical direction can be minimized. Moreover, in the film-forming device 1, since the second cylinder 45 accommodating the second supply pipe 23 can be fixed to the top of the upper chamber 15, there is no need to provide any special member for supporting the second cylinder 45. In addition, the gas transportation portion 5 can have a compact size.

Subsequently, according to the film-forming device 1, the first gas flow channel 26 and the second gas flow channel 27 of the gas supply pipe 20 can be prevented in advance from being shut down.

That is, when the vacuum chamber 10 is exposed to the atmosphere after a barrier film is formed, particles (minute peeling pieces) are generated on surfaces of components equal to the barrier film adhered inside the gas supply pipe 20 or the vacuum chamber 10, so that the particles can invade the first gas flow channel 26 and the second gas flow channel 27, resulting in a shut-down. In addition, in a case where the medium gas G reacts to oxygen or moisture in the atmosphere and compounds can be generated, these compounds will cause a shut-down of the gas flow channels, similar to the particles.

Incidentally, according to the film-forming device 1, since the first gas flow channel 26 and the second gas flow channel 27 are subjected to vacuum drawing while being on standby, the particles or the compounds do not invade the first gas flow channel 26 and the second gas flow channel 27.

As described above, according to the film-forming device 1, the required gas supply pipe 20 can be maintained at the film-forming start position P1 of a barrier film in a sound state. Therefore, according to the film-forming device 1, the frequency of maintenance for a shut-down of the gas supply pipe 20 is reduced, so that a continuous operation for a long period of time can be ensured.

Subsequently, according to the film-forming device 1, the heat generating unit 30 can be prevented from breaking due to reaction to nitrogen, oxygen, or the like.

Since the temperature of the heat generating unit 30 becomes high exceeding 1,000°C while forming a barrier film, even though film-forming ends and the heat generating unit 30 stops being energized, a considerably high temperature is maintained. Therefore, when this heat generating unit 30 in a high-temperature state comes into contact with the atmosphere, parts in the vicinity of the surface of the heat generating unit 30 react to mainly nitrogen and oxygen in the atmosphere, and there is concern that the heat generating unit 30 falls into a breakage state where the original function is extinguished.

Incidentally, according to the film-forming device 1, after film-forming, since the heat generating unit 30 is accommodated in the pressure-reducing chamber 43 which has been subjected to vacuum exhaust together with the gas supply pipe 20. Accordingly, reaction to nitrogen, oxygen, or the like is suppressed, and the heat generating unit 30 can be maintained in a sound state. Therefore, according to the film-forming device 1, the frequency of maintenance for the heat generating unit 30 is reduced, so that a continuous operation for a long period of time can be ensured.

Subsequently, according to the film-forming device 1, as means for reducing pressure in the first gas flow channel 26 of the gas supply pipe 20, the cylinder 40 having the pressure-reducing chamber 43 is provided, and the pressure in the pressure-reducing chamber 43 is reduced via the first gas flow channel 26 in communication with this pressure-reducing chamber 43. Since the position of this cylinder 40 is fixed, a mechanism for reducing pressure can be simplified. Furthermore, since the cylinder 40 functions as a guide for moving the gas supply pipe 20 upward and downward, there is no need to separately provide a guiding mechanism for the gas supply pipe 20. Moreover, since it is sufficient for the pressure-reducing chamber 43 to have a minimum space required for the gas supply pipe 20 to move upward and downward, the time required to reduce the pressure in the gas flow channel 26 can be minimized. Moreover, it is sufficient for the cylinder 40 to have a minimum space only for accommodating the gas supply pipe 20. Therefore, the pressure-reduced state of the pressure-reducing chamber 43 inside the cylinder 40 can be easily maintained.

In addition, in the film-forming device 1, the first cylinder 41 is attached to the upper chamber 15, and the pressure-reducing chamber 43 communicates with the film-forming chamber 11. In this manner, in the film-forming device 1, since the first cylinder 41 in which the first supply pipe 21 is accommodated so as to be able to advance and retreat is directly connected to the vacuum chamber 10 without passing through the piping, the configuration of the device can be simple and compact.

Hereinabove, a preferable embodiment of the present invention has been described. Unless the configuration departs from the gist of the present invention, the configurations exemplified in the embodiment described above can be selectively adopted and abandoned or suitably changed to a different configuration.

In addition, in the embodiment described above, although power stops being supplied to the heat generating unit 30 and film-forming ends, the medium gas G continues to be supplied. However, the medium gas G can stop being supplied to the gas supply pipe 20. In this case, even after power stops being supplied to the heat generating unit 30, the heat generating unit 30 is in a high temperature region. Accordingly, it is preferable that the medium gas G continues to be supplied because oxidation or the like of the heat generating body 31 can be prevented by spraying the medium gas G to the heat generating body 31. However, if the heat generating body 31 can be cooled to the extent that oxidation or the like does not occur, the medium gas G can stop being supplied after film-forming ends.

In addition, the embodiment described above has illustrated an example of using an oscillating-type shielding gate 18 for partitioning the chamber into the film-forming chamber 11 and the pressure-reducing chamber 43. However, a sliding-type shielding gate can be used.

In addition, the embodiment described above has illustrated the cylinder 40 remaining the minimum space required for moving the gas supply pipe 20 upward and downward. However, the present invention is not limited thereto. A cylinder having room with respect to the gas supply pipe 20 may be employed. In this case, when the pressure-reducing chamber 43 is enlarged more than that is required, it takes time to reduce pressure and discharge air. Therefore, it is preferable to reduce the volume as much as possible. Depending on the size of the container P to be subjected to film-forming, it is preferable that the volume of the pressure-reducing chamber 43 is equal to or smaller than that of the film-forming chamber 11.

In addition, in the embodiment described above, the first supply pipe 21 and the second supply pipe 23 are reversed at a part of the connection pipe 22 in which both are connected to each other. It is considered to be preferable for minimizing the dimension of the film-forming device 1 in the vertical direction. However, the present invention does not exclude a configuration in which the first supply pipe 21 and the second supply pipe 23 are linearly connected to each other.

In addition, for example, a resin configuring the container P used in the present invention is arbitrary. Examples of the resin include a polyethylene terephthalate resin (PET), a polybutylene terephthalate resin, a polyethylene naphthalate resin, a polyethylene resin, a polypropylene resin (PP), and a cycloolefin copolymer resin (COC, cyclic olefin copolymerization).

In addition, the usage of the container used in the present invention is arbitrary. For example, the container can be widely used as a container accommodating beverages such as water, tea drinks, soft drinks, carbonated drinks, and fruit juice drinks; and food in liquid, viscous body, powder, or solid form.

In addition, the material of a barrier film is also arbitrary. It is possible to apply various kinds of materials such as substances which can form a film by using the medium gas G through the CVD method, typically, a carbon film, a silica film, and an alumina film.

An amorphous carbon film is a specific example of a carbon film. The amorphous carbon film is a carbon film having a structure in an amorphous state in which diamond components (bond of carbon atoms is SP³ bond), graphite components (bond of carbon atoms is SP² bond), and polymer components (bond of carbon atoms is SP¹ bond) are mixed. The amorphous carbon film denotes a film of which hardness varies due to a change of the abundance ratio of binding components of the carbon atoms thereof, including a hard carbon film and a soft carbon film. In addition, the amorphous carbon film also includes a hydrogenated amorphous carbon containing hydrogen. Moreover, a hard carbon film also includes an amorphous DLC film having SP³ bonds as main bodies.

In addition, as alternative barrier films, it is possible to use a SiOx film, an AlOx film, a hydrogen containing SiNx film, a hydrogen containing DLC film, a hydrogen containing SiOx film, a hydrogen containing SiCxNy film, and the like.

### Reference Signs List

- 1: FILM-FORMING DEVICE
- 3: FILM-FORMING PORTION
- 5: GAS TRANSPORTATION PORTION
- 10: VACUUM CHAMBER
- 11: FILM-FORMING CHAMBER
- 13: LOWER CHAMBER
- 14: ENTRY WAY
- 15: UPPER CHAMBER
- 16: EXHAUST PASSAGE
- 17: THROUGH WINDOW
- 18: SHIELDING GATE
- 20: GAS SUPPLY PIPE
- 21: FIRST SUPPLY PIPE
- 22: CONNECTION PIPE
- 23: SECOND SUPPLY PIPE
- 24: FIRST PISTON
- 25: SECOND PISTON
- 26: FIRST GAS FLOW CHANNEL
- 27: SECOND GAS FLOW CHANNEL
- 28: NOZZLE
- 29: RAW MATERIAL TANK
- 30: HEAT GENERATING UNIT
- 31: HEAT GENERATING BODY
- 33: LEAD
- 40: CYLINDER
- 41: FIRST CYLINDER
- 42: CYLINDER MAIN BODY
- 42h: OPENING
- 43: PRESSURE-REDUCING CHAMBER
- 44: EXHAUST PORT
- 45: SECOND CYLINDER
- 46: CYLINDER MAIN BODY
- 47: STORAGE CHAMBER
- 48: AIR SUPPLY PORT
- 49: PIPING
- G: MEDIUM GAS
- P: CONTAINER
- P1: FILM-FORMING START POSITION
- P2: FILM-FORMING COMPLETION POSITION
- P3: STANDBY POSITION

## Claims

1. A film-forming device comprising:
a chamber which has a film-forming chamber (11) accommodating a container (P) for forming a gas barrier film, wherein the film-forming device is configured such that the film-forming chamber (11) is in a vacuum state when the gas barrier film is formed;
a gas supply pipe (20) which has a gas flow channel for introducing a medium gas (G) for forming the gas barrier film into the container (P) and is moveable upward and downward along an axis line direction thereof;
a cylinder (40) in which the gas supply pipe (20) is arranged movably upward and downward; and
a heat generating body (31) configured to generate heat when power is supplied,
wherein the gas supply pipe (20) includes
a first supply pipe (21) adapted to advance and retreat in the film-forming chamber (11), wherein the first supply pipe (21) internally has a first gas flow channel (26), and wherein the first supply pipe (21) is adapted to discharge the medium gas (G) from a tip end toward the heat generating body (31), and
a second supply pipe (23) which internally has a second gas flow channel (27) in communication with the first gas flow channel (26) and is connected to the first supply pipe (21),
wherein the cylinder (40) includes
a first cylinder (41) in which the first supply pipe (21) is arranged movably upward and downward, has a pressure-reducing chamber (43) in communication with the first gas flow channel (26), and is fixed to the chamber, and
a second cylinder (45) in which the second supply pipe (23) is arranged movably upward and downward and has a storage chamber (47) in communication with the second gas flow channel (27), and
wherein the film forming device is configured such that medium gas (G) supplied to the storage chamber (47) passes through the second supply pipe (23) and the first supply pipe (21) in this order and is supplied to the container (P).

2. The film-forming device according to Claim 1, further comprising:
a heat generating unit (30) which is supported by the first supply pipe (21),
wherein the heat generating unit (30) has
the heat generating body (31) which generates heat when power is supplied and
a pair of leads (33) which is electrically connected to the heat generating body (31), and
wherein the heat generating body (31) is disposed in the vicinity of the tip end of the first supply pipe (21).

3. The film-forming device according to Claim 1 or 2,
wherein the second cylinder (45) is fixed to the chamber in a state of being adjacent to the first cylinder (41).

4. The film-forming device according to any one of Claims 1 to 3,
wherein the first supply pipe (21) is constituted of
a tip portion of which a length of a portion accommodated in the first cylinder (41) is L1 while being on standby during which no gas barrier film is formed, and
a rear end portion which is connected to the tip portion and of which a length of a portion accommodated in the first cylinder (41) is L2 during film-forming, and
wherein when a length of the second supply pipe (23) is L3, L1 ≤ L2 and L1 ≤ L3 are satisfied.

5. The film-forming device according to any one of Claims 1 to 4,
wherein the first supply pipe (21) is retreatable from the film-forming chamber (11) and is accommodatable in the first cylinder (41) while being on standby during which no gas barrier film is formed, and the first gas flow channel (26) is subjected to vacuum drawing.

6. The film-forming device according to any one of Claims 1 to 5, further comprising:
a shielding gate (18) which is configured to block communication between the film-forming chamber (11) and the pressure-reducing chamber (43) when the first supply pipe (21) retreats from the film-forming chamber (11).

7. The film-forming device according to Claim 5 or 6,
further configured such that the medium gas (G) is supplied to the film-forming chamber (11) via the gas supply pipe (20) continuously as much as a predetermined period of time while being on standby after forming of the gas barrier film ends.

8. The film-forming device according to any one of Claims 1 to 7,
wherein the first supply pipe (21) and the second supply pipe (23) are connected to each other via a connection pipe (22) and arranged reversed, such that after passing through the connection pipe 22 via the second supply pipe 23, the medium gas G flows in the first supply pipe 21 in a reverse direction and is discharged from the opening at a tip end of the first supply pipe 21.

## Patentansprüche

1. Vorrichtung zur Filmherstellung umfassend:
eine Kammer, die eine filmherstellende Kammer (11) aufweist, in der ein Behälter (P) zur Herstellung eines Gassperrfilms aufgenommen ist, wobei die Vorrichtung zur Filmherstellung derart ausgebildet ist, dass sich die filmherstellende Kammer (11) in einem Vakuumzustand befindet, wenn der Gassperrfilm hergestellt wird,
eine Gaszufuhrleitung (20), die einen Gasflusskanal zur Einleitung eines Mediumgases (G) zur Herstellung des Gassperrfilms in den Behälter (P) aufweist und entlang einer Achslinienrichtung davon aufwärts und abwärts bewegbar ist,
einen Zylinder (40), in dem die Gaszufuhrleitung (20) aufwärts und abwärts bewegbar angeordnet ist; und
einen Wärme erzeugenden Körper (31), der ausgebildet ist, Wärme zu erzeugen, wenn er mit Strom versorgt wird,
wobei die Gaszufuhrleitung (20) beinhaltet
eine erste Zufuhrleitung (21), die ausgelegt ist, sich in der filmherstellenden Kammer (11) vorwärts und rückwärts zu bewegen, wobei die erste Zufuhrleitung (21) im Inneren einen ersten Gasflusskanal (26) aufweist, und wobei die erste Zufuhrleitung (21) ausgelegt ist, das Mediumgas (G) von einem Kopfende zum Wärme erzeugenden Körper (31) hin auszustoßen, und
eine zweite Zufuhrleitung (23), die im Inneren einen zweiten Gasflusskanal (27) aufweist, der mit dem ersten Gasflusskanal (26) in Verbindung steht und mit der ersten Zufuhrleitung (21) verbunden ist,
wobei der Zylinder (40) beinhaltet
einen ersten Zylinder (41), in dem die erste Zufuhrleitung (21) aufwärts und abwärts bewegbar angeordnet ist, eine in Verbindung mit dem ersten Gasflusskanal (26) stehende Druck verringernde Kammer (43) aufweist und an der Kammer befestigt ist, und
einen zweiten Zylinder (45), in dem die zweite Zufuhrleitung (23) aufwärts und abwärts bewegbar angeordnet ist und eine in Verbindung mit dem zweiten Gasflusskanal (27) stehende Speicherkammer (47) aufweist, und
wobei die Vorrichtung zur Filmherstellung derart ausgebildet ist, dass zur Speicherkammer (47) zugeführtes Mediumgas (G) durch die zweite Zufuhrleitung (23) und die erste Zufuhrleitung (21) in dieser Reihenfolge strömt und dem Behälter (P) zugeführt wird.

2. Vorrichtung zur Filmherstellung nach Anspruch 1, weiter umfassend:
eine Wärme erzeugende Einheit (30), die durch die erste Zufuhrleitung (21) getragen wird,
wobei die Wärme erzeugende Einheit (30) aufweist
den Wärme erzeugenden Körper (31), der Wärme erzeugt, wenn er mit Strom versorgt wird, und
ein Paar Stromleitungen (33), das mit dem Wärme erzeugenden Körper (31) elektrisch verbunden ist, und
wobei der Wärme erzeugende Körper (31) in der Nähe des Kopfendes der ersten Zufuhrleitung (21) angeordnet ist.

3. Vorrichtung zur Filmherstellung nach Anspruch 1 oder 2,
wobei der zweite Zylinder (45) in einem Zustand, dass er zum ersten Zylinder (41) benachbart ist, an der Kammer befestigt ist.

4. Vorrichtung zur Filmherstellung nach einem der Ansprüche 1 bis 3,
wobei die erste Zufuhrleitung (21) gebildet ist aus
einem Kopfabschnitt, von dem eine Länge eines im ersten Zylinder (41) aufgenommenen Abschnitts L1 beträgt, während er sich in einem Bereitschaftsmodus befindet, bei dem kein Gassperrfilm hergestellt wird, und
einem hinteren Endabschnitt, der mit dem Kopfabschnitt verbunden ist und von dem eine Länge eines im ersten Zylinder (41) aufgenommenen Abschnitts während der Filmherstellung L2 beträgt, und
wobei, wenn eine Länge der zweiten Zufuhrleitung (23) L3 beträgt, L1 ≤ L2 und L1 ≤ L3 erfüllt sind.

5. Vorrichtung zur Filmherstellung nach einem der Ansprüche 1 bis 4,
wobei die erste Zufuhrleitung (21) aus der filmherstellenden Kammer (11) zurückbewegbar und im ersten Zylinder (41) im Bereitschaftsmodus, bei dem kein Gassperrfilm hergestellt wird, und der erste Gasflusskanal (26) mit Vakuum beaufschlagt wird, aufnehmbar ist.

6. Vorrichtung zur Filmherstellung nach einem der Ansprüche 1 bis 5, weiter umfassend:
ein Abschirmgate (18), das ausgebildet ist, eine Verbindung zwischen der filmherstellenden Kammer (11) und der Druck verringernden Kammer (43) zu verschließen, wenn sich die erste Zufuhrleitung (21) aus der filmherstellenden Kammer (11) zurückbewegt.

7. Vorrichtung zur Filmherstellung nach Anspruch 5 oder 6,
die weiter derart ausgebildet ist, dass das Mediumgas (G) während des Bereitschaftsmodus, nachdem die Herstellung des Gassperrfilms beendet wurde, über die Gaszufuhrleitung (20) für eine vorbestimmte Zeitdauer zu der filmherstellenden Kammer (11) kontinuierlich zugeführt wird.

8. Vorrichtung zur Filmherstellung nach einem der Ansprüche 1 bis 7,
wobei die erste Zufuhrleitung (21) und die zweite Zufuhrleitung (23) miteinander über eine Verbindungsleitung (22) verbunden und umgekehrt angeordnet sind, so dass das Mediumgas (G) nach Durchströmen der Verbindungsleitung (22) über die zweite Zufuhrleitung (23) in einer umgekehrten Richtung in der ersten Zufuhrleitung (21) fließt und aus der Öffnung an einem Kopfende der ersten Zufuhrleitung (21) ausgestoßen wird.

## Revendications

1. Dispositif de formation de film comprenant :
une chambre qui a une chambre de formation de film (11) recevant un récipient (P) pour former un film barrière aux gaz, dans lequel le dispositif de formation de film est configuré de sorte que la chambre de formation de film (11) est dans un état de vide lorsqu'un film barrière aux gaz est formé ;
un tuyau d'alimentation en gaz (20) qui a un canal d'écoulement de gaz pour introduire un gaz porteur (G) pour former le film barrière aux gaz dans le récipient (P) et qui peut être déplacé vers le haut et vers le bas le long d'une direction de son axe ;
un cylindre (40) dans lequel le tuyau d'alimentation en gaz (20) est disposé de façon mobile vers le haut et vers le bas ; et
un corps générant de la chaleur (31) configuré pour générer de la chaleur lorsque de l'énergie est fournie,
dans lequel le tuyau d'alimentation en gaz (20) inclut
un premier tuyau d'alimentation (21) adapté pour avancer et reculer dans la chambre de formation de film (11), dans lequel le premier tuyau d'alimentation (21) a intérieurement un premier canal d'écoulement de gaz (26), et dans lequel le premier tuyau d'alimentation (21) est adapté pour décharger le gaz porteur (G) d'une extrémité de pointe vers le corps générant de la chaleur (31), et
un second tuyau d'alimentation (23) qui comporte intérieurement un second canal d'écoulement de gaz (27) en communication avec le premier canal d'écoulement de gaz (26) et est connecté au premier tuyau d'alimentation (21),
dans lequel le cylindre (40) inclut
un premier cylindre (41) dans lequel le premier tuyau d'alimentation (21) est disposé de façon mobile vers le haut et vers le bas, a une chambre de réduction de pression (43) en communication avec le premier canal d'écoulement de gaz (26), et est fixé à la chambre, et
un second cylindre (45) dans lequel le second tuyau d'alimentation (23) est disposé de façon mobile vers le haut et vers le bas et a une chambre de stockage (47) en communication avec le second canal d'écoulement de gaz (27), et
dans lequel le dispositif de formation de film est configuré de sorte que le gaz porteur (G) fourni à la chambre de stockage (47) passe à travers le second tuyau d'alimentation (23) et le premier tuyau d'alimentation (21) dans cet ordre et est fourni au récipient (P).

2. Dispositif de formation de film selon la revendication 1, comprenant en outre :
une unité de génération de chaleur (30) qui est supportée par le premier tuyau d'alimentation (21),
dans lequel l'unité de génération de chaleur (30) a
le corps générant de la chaleur (31) qui génère de la chaleur lorsque de l'énergie est fournie et
une paire de conducteurs (33) qui est électriquement connectée au corps générant de la chaleur (31), et
dans lequel le corps générant de la chaleur (31) est disposé à proximité de l'extrémité de pointe du premier tuyau d'alimentation (21).

3. Dispositif de formation de film selon la revendication 1 ou 2,
dans lequel le second cylindre (45) est fixé à la chambre dans un état adjacent au premier cylindre (41).

4. Dispositif de formation de film selon une quelconque des revendications 1 à 3,
dans lequel le premier tuyau d'alimentation (21) est constitué
d'une partie de pointe dont une longueur d'une partie logée dans le premier cylindre (41) est L1 tout en étant en attente, pendant laquelle aucun film barrière aux gaz n'est formé, et
d'une partie d'extrémité arrière qui est connectée à la partie de pointe et dont une longueur d'une partie logée dans le premier cylindre (41) est L2 pendant une formation de film, et
dans lequel, quand une longueur du second tuyau d'alimentation (23) est L3, L1 ≤ L2 et L1 ≤ L3 sont satisfaits.

5. Dispositif de formation de film selon une quelconque des revendications 1 à 4,
dans lequel le premier tuyau d'alimentation (21) peut être retiré de la chambre de formation de film (11) et peut être logé dans le premier cylindre (41) tout en étant en attente, pendant laquelle aucun film barrière aux gaz n'est formé, et le premier canal d'écoulement de gaz (26) est soumis à un tirage au vide.

6. Dispositif de formation de film selon une quelconque des revendications 1 à 5, comprenant en outre :
une porte de blindage (18) qui est configurée pour bloquer une communication entre la chambre de formation de film (11) et la chambre de réduction de pression (43) lorsque le premier tuyau d'alimentation (21) se retire de la chambre de formation de film (11).

7. Dispositif de formation de film selon la revendication 5 ou 6,
configuré en outre de sorte que le gaz porteur (G) est fourni à la chambre de formation de film (11) via le tuyau d'alimentation en gaz (20) de manière continue jusqu'à une période de temps prédéterminée tout en étant en attente après la fin de la formation du film barrière aux gaz.

8. Dispositif de formation de film selon une quelconque des revendications 1 à 7,
dans lequel le premier tuyau d'alimentation (21) et le second tuyau d'alimentation (23) sont connectés l'un à l'autre via un tuyau de raccordement (22) et disposés en sens inverse, de sorte qu'après un passage à travers le tuyau de raccordement (22) via le second tuyau d'alimentation (23), le gaz porteur G s'écoule dans le premier tuyau d'alimentation (21) dans un sens inverse et est déchargé de l'ouverture à une extrémité du premier tuyau d'alimentation (21).
